# EUROPÄISCHE PATENTANMELDUNG

(11) **EP 3 297 036 A1**
(43) Veröffentlichungstag der Anmeldung: **21.03.2018**
(21) Anmeldenummer: 17200330.3
(22) Anmeldetag: 24.09.2010
(51) Int. Cl.: H01L 31/0203, H01L 33/48, H01L 33/00, H01L 31/0232, H01L 33/58, H01L 33/60, H01L 23/00, H01L 33/52, H01L 31/02

(54) **VERFAHREN ZUM HERSTELLEN EINER ANORDNUNG MIT EINEM BAUELEMENT AUF EINEM TRÄGERSUBSTRAT UND ANORDNUNG SOWIE VERFAHREN ZUM HERSTELLEN EINES HALBZEUGES**

(30) Priorität: 24.09.2009 DE 102009042479
(62) Teilanmeldung aus: 10782530.9
(71) Anmelder: MSG Lithoglas GmbH, 01109 Dresden (DE)
(72) Erfinder: HANSEN, Dr. Ulli, 10555 Berlin (DE); LEIB, Dr. Jürgen, 91077 Neunkirchen am Brand (DE); MAUS, Simon, 10781 Berlin (DE)
(74) Vertreter: Bittner, Thomas L.

(57) **Zusammenfassung**

Die Erfindung bezieht sich auf ein Verfahren zum Herstellen einer Anordnung mit einem Bauelement (23) auf einem Trägersubstrat (20), wobei das Verfahren die folgenden Schritte umfasst: Herstellen von Abstandselementen (1) auf der Rückseite eines Decksubstrats (3), wobei in einem Substrat (4) Vertiefungen (5) auf einer Seite angebracht werden, auf dieser Seite das Decksubstrat angeordnent wird, so dass ein Vertiefungshohlraum entsteht und das Substrat von der gegenüberliegenden Seite rückgedünnt wird, so dass dieser Hohlraum geöffnet wird, womit getrennte Abstandselemente (1) entstehen, Anordnen eines Bauelementes (22) auf einer Deckfläche eines Trägersubstrates (20) und Anordnen der an dem Decksubstrat (3) gebildeten Abstandselemente (1) auf dem Trägersubstrat (20), derart, dass das Bauelement (22) in dem wenigstens einen Hohlraum (23) angeordnet und dieser geschlossen wird. Des Weiteren bezieht sich die Erfindung auf eine Anordnung und ein Verfahren zum Herstellen eines Halbzeugs für eine Bauelementanordnung.

## Beschreibung

Die Erfindung betrifft ein Verfahren zum Herstellen einer Anordnung mit einem Bauelement auf einem Trägersubstrat und Anordnung sowie Verfahren zum Herstellen eines Halbzeuges.

### Hintergrund

Insbesondere in Verbindung mit elektronischen Bauelementen sind Anordnungen bekannt, bei denen das elektronische Bauelement auf einem Trägersubstrat aufgebracht wird, beispielsweise einem Halbleitermaterial. Es sind verschiedene Vorschläge für Anordnungen gemacht worden, bei denen das Bauelement in einem Hohlraum angeordnet wird, was auch als Verkapseln oder Kapseln bezeichnet wird.

So ist aus dem Dokument US 6,932,519 B2 eine Anordnung bekannt, bei der ein optisches Bauelement in einer auf dem Trägersubstrat gebildeten Vertiefung angeordnet ist. Mittels Abstandselementen, die seitlich der Vertiefung auf der Deckfläche des Trägersubstrats angeordnet sind, ist zur Ausbildung des Hohlraums ein Decksubstrat beabstandet von dem Trägersubstrat angeordnet. Die Vertiefung in dem Trägersubstrat ist mit schräg oder geneigt verlaufenden Randflächen gebildet.

In dem Dokument US 6,969,639 B2 ist eine Anordnung offenbart, bei der ein elektronisches Bauelement auf der Deckfläche des Trägersubstrats und in einem mittels Abstandselementen und einem Decksubstrat gebildeten Hohlraum angeordnet ist. Aus dem Hohlraum heraus geführt ist eine elektrische Kontaktierung für das elektronische Bauelement.

Aus dem Dokument DE 10 2007 039 291 A1 sind ein optoelektronisches Halbleitermodul und Verfahren zur Herstellung eines solchen bekannt. Das optoelektronische Halbleitermodul verfügt über einen Chipträger, einen auf dem Chipträger montierten lichtemittierenden Halbleiterchip und ein Abdeckelement, dass eine zumindest teilweise lichtdurchlässige Abdeckplatte, die auf der von dem Chipträger abgewandten Seite des Halbleiterchips angeordnet ist, und ein Rahmenteil aufweist, wobei das Rahmenteil den Halbleiterchip seitlich umgibt. Das Rahmenteil ist fügeschichtlos mit der Abdeckplatte verbunden und an seiner von der Abdeckplatte entfernten Seite mit dem Chipträger verbunden. Mit dem Rahmenteil sind Abstandshalter gebildet, die Hohlräume zur Aufnahme von Bauelementen begrenzen. Zur Herstellung des Rahmenteils wird ein sogenannter Rahmenwafer mit einer Maskenschicht versehen, die einseitig strukturiert ist. Mittels Ätzen durch den Rahmenwafer hindurch werden dann in diesem Öffnungen erzeugt. Anschließend wird die Maskenschicht entfernt und das Rahmenteil auf einem Abdeckplattenwafer aufgebracht, sodass Hohlräume zur Aufnahme von Bauelementen gebildet sind.

Das bekannte Verfahren weist Nachteile auf, wenn dünne Abstandshalter oder große Stückzahlen zu niedrigen Kosten hergestellt werden sollen. Die nach dem bekannten Verfahren notwendigen dünnen Rahmenwafer sind fragil und bergen ein hohes Bruchrisiko beim Aufbringen auf den Abdeckplattenwafer. Zudem besitzen die Rahmenwafer durchgängige Öffnungen, die ein automatisches Handling mit industrieüblichen Vakuumhandlern ausschließen. Zwar kann dieses Problem mittels temporär gebondeter Carrierwafer für manche Applikationen umgangen werden, was aber zu zusätzlichen Materialeinsatz und zusätzlichen Prozessschritten und damit zu erhöhten Kosten führt.

Das Dokument DE 10 2004 025 735 A1 offenbart ein Gehäuse für einen optischen Empfänger, bei dem der Empfänger in einem Hohlraum angeordnet ist.

Das Dokument DE 10 2004 025 775 A1 offenbart Oberflächenemissionslasergehäuse, welche ein integriertes optisches Element und einen integrierten Ausrichtungspfosten aufweisen.

Im Dokument EP 1 729 350 A2 ist ein sogenanntes LED-Package offenbart.

Auch das Dokument US 2002/0018911 A1 betrifft ein optoelektronisches Element, bei dem Bauelemente gekapselt sind.

Im Dokument EP 0 305 112 B1 ist eine Vorrichtung zum Koppeln eines optischen Filters an eine optoelektronische Vorrichtung beschrieben.

Eine bipolare Beleuchtungsquelle aus einem einseitig kontaktierten, selbstbündelnden Halbleiterkörper ist in dem Dokument DE 199 63 550 A1 offenbart.

Im Dokument DE 10 2004 045 947 A1 ist eine Leuchtdiodenanordnung beschrieben, bei der die Leuchtdiode in einem Hohlraum angeordnet ist.

Das Dokument EP 0 731 509 A1 offenbart einen optoelektronischen Wandler sowie ein Herstellungsverfahren, bei auf einer Bodenplatte Abstandshalter angeordnet sind, die ein Linsensystem tragen.

Auch das Dokument US 209/0001405 A1 bezieht sich auf ein lichtemittierendes Bauelement, bei dem ein Rahmenteil Aufnahmeräume für Bauelemente bildet.

### Zusammenfassung

Aufgabe der Erfindung ist es, verbesserte Technologien für eine Anordnung mit einem Bauelement auf einem Trägersubstrat, insbesondere einem elektronischen Bauelement, zu schaffen, mit denen die Anwendungsmöglichkeiten in Verbindung mit gekapselten Bauelementen optimiert sind und eine kostengünstige Herstellung mit hohen Ausbeuten ermöglicht ist. Bevorzugt soll die Kapselung hermetisch- oder quasihermetisch ausgeführt sein, insbesondere gegenüber Umgebungsfeuchtigkeit.

Diese Aufgabe wird erfindungsgemäß durch ein Verfahren zum Herstellen einer Anordnung mit einem Bauelement auf einem Trägersubstrat nach dem unabhängigen Anspruch 1 sowie einer Anordnung nach dem unabhängigen Anspruch 13 gelöst. Weiterhin ist ein Verfahren zum Herstellen eines Halbzeugs für eine Bauelementanordnung mit einem gekapselten Bauelement nach dem unabhängigen Anspruch 15 geschaffen. Vorteilhafte Ausgestaltungen der Erfindung sind Gegenstand von abhängigen Unteransprüchen.

Nach einem Aspekt ist ein Verfahren zum Herstellen einer Anordnung mit einem Bauelement auf einem Trägersubstrat geschaffen, bei dem Abstandselemente auf der Rückseite eines Decksubstrats hergestellt werden. Beim Herstellen der Abstandselemente sind die folgenden Schritte vorgesehen: Bereitstellen eines Substrats, Herstellen einer oder mehrerer Vertiefungen im Bereich einer ausgewählten Oberfläche des Substrats, Anordnen des Decksubstrates auf der ausgewählten Oberfläche des Substrats, derart, dass wenigstens ein Vertiefungshohlraum gebildet wird, und Rückdünnen des Substrats von einer zur ausgewählten Oberfläche entgegen gesetzten Oberfläche des Substrats aus, derart, dass der wenigstens eine Vertiefungshohlraum geöffnet wird und so getrennte Abstandselemente gebildet werden, die zusammen mit dem Decksubstrat wenigstens einen Hohlraum begrenzen, der im Bereich der entgegen gesetzten Oberfläche des Substrats geöffnet ist. Weiterhin ist dann noch vorgesehen, dass ein Bauelement auf einer Deckfläche eines Trägersubstrates angeordnet wird und die an dem Decksubstrat gebildeten Abstandselemente auf dem Trägersubstrat angeordnet werden, derart, dass das Bauelement in dem wenigstens einen Hohlraum angeordnet und dieser geschlossen wird.

Nach einem weiteren Aspekt ist eine Anordnung geschaffen, die nach dem vorangehenden Verfahren hergestellt ist und die folgenden Merkmale aufweist: ein Trägersubstrat, ein gekapseltes Bauelement, welches auf einer Deckfläche des Trägersubstrates in einem Hohlraum angeordnet ist, und eine elektrische Kontaktierung des Bauelementes, wobei der Hohlraum mittels auf der Deckfläche des Trägersubstrates angeordneter Abstandselemente und eines auf den Abstandselementen lagernden Decksubstrats gebildet ist und wobei die Abstandselemente eine Beschichtung in Form einer Metallisierung und / oder einer optischen Verspiegelung aufweisen.

Es kann vorgesehen, dass die Abstandselemente eine Höhe von etwa 10µm bis etwa 300µm, bevorzugt eine Höhe von etwa 30µm bis etwa 300µm und weiter bevorzugt eine Höhe von etwa 30µm bis etwa 100µm aufweisen.

Es wurde überraschend gefunden, dass das vorangehend beschriebene Verfahren die zuverlässige und reproduzierbare Herstellung von Abstandselementen mit solchen vergleichsweise geringen Bauhöhen ermöglicht.

Nach einem anderen Aspekt ist ein Verfahren zum Herstellen eines Halbzeugs für eine Bauelementanordnung geschaffen, insbesondere für eine Bauelementanordnung mit einem gekapselten Bauelement, wobei das Verfahren die folgenden Schritte umfasst: Bereitstellen eines Decksubstrats und Herstellen von Abstandselementen und eines zwischen den Abstandselementen gebildeten Aufnahmeraums auf einer Rückseite des Decksubstrates, wobei der Aufnahmeraum konfiguriert ist für eine gekapselte Aufnahme wenigstens eines Bauelementes beim Anordnen des Decksubstrates auf einem Trägersubstrat. Das Herstellen der Abstandselemente umfasst die folgenden Schritte: Bereitstellen eines Substrats, Herstellen einer oder mehrerer Vertiefungen im Bereich einer ausgewählten Oberfläche des Substrats, Anordnen des Decksubstrates auf der ausgewählten Oberfläche des Substrats, derart, dass wenigstens ein Vertiefungshohlraum gebildet wird, und Rückdünnen des Substrats von einer zur ausgewählten Oberfläche entgegen gesetzten Oberfläche des Substrats aus, derart, dass der wenigstens eine Vertiefungshohlraum geöffnet wird und so getrennte Abstandselemente gebildet werden, die zusammen mit dem Decksubstrat den Aufnahmeraum begrenzen, der im Bereich der entgegen gesetzten Oberfläche des Substrats geöffnet ist.

Weiterhin sieht ein Aspekt ein Halbzeug für eine Bauelementanordnung, hergestellt nach dem vorgenannten Verfahren vor, bei dem an einem Decksubstrat auf der Rückseite strukturierte Abstandselemente und zwischen den strukturierten Abstandselementen wenigstens ein Vertiefungshohlraum gebildet sind, welcher für die Aufnahme eines Bauelementes konfiguriert ist, wobei die Abstandselemente eine Höhe von etwa 10µm bis etwa 300µm, bevorzugt eine Höhe von etwa 30µm bis etwa 300µm und weiter bevorzugt eine Höhe von etwa 30µm bis etwa 100µm aufweisen.

Mit dem vorgeschlagenen Verfahren ist die Möglichkeit geschaffen, Abstandselemente in strukturierter Form (strukturierte Abstandselemente) zunächst unabhängig von dem Trägersubstrat und dem hierauf angeordneten Bauelement, bei dem es sich insbesondere um ein elektrisches oder elektronisches Bauelement handelt, auf der Rückseite des Decksubstrats herzustellen, um dann mit den beiden Halbzeugen, nämlich Trägersubstrat mit hierauf angeordnetem Bauelement einerseits und Decksubstrat mit auf der Rückseite gebildeten Abstandselementen andererseits, eine Anordnung herzustellen. Das Ausbilden der Abstandselemente auf der Rückseite des Decksubstrats kann somit ohne Rücksicht auf eventuelle Einflüsse dieser Herstellungsschritte auf das Trägersubstrat oder das Bauelement erfolgen, da lediglich Decksubstrat und Abstandselemente bearbeitet werden. In ähnlicher Weise erfolgt das Anordnen des Bauelementes auf der Deckfläche des Trägersubstrats unabhängig von den Abstandselementen. Das Rückdünnen ermöglicht es in besonderer Weise, die Abstandselemente mit einer gewünschten Höhe herzustellen. Je nach Situation kann eine dem Anwendungsfall entsprechende Höhe erzeugt werden, insbesondere auch zum Ausbilden von Abstandshaltern mit im Vergleich zu bekannten Anordnungen verkleinerten Bauhöhen.

Bei einer vorteilhaften Ausgestaltung der Erfindung kann vorgesehen sein, dass das Anordnen der an dem Decksubstrat gebildeten Abstandselemente einen Schritt zum Ausbilden eines weiteren Hohlraums / Aufnahmeraums mit einem weiteren Bauelement umfasst. In Verbindung mit dem weiteren Hohlraum / Aufnahmeraum gelten die im Zusammenhang mit dem Hohlraum vorangehend und nachfolgend gemachten Erläuterungen entsprechend.

Bei dem Substrat handelt es sich beispielsweise um ein Halbleitersubstrat, zum Beispiel Si, in welchem die eine oder die mehreren Vertiefungen beispielsweise mittels Trocken -oder Nassätzen hergestellt werden. Es kann vorgesehen sein, eventuell gebildete Metallisierungen oder dielektrische Schichten noch vor oder nach dem Anordnen des Decksubstrats auf der Oberfläche des Substrats herzustellen. In dieser oder anderen Ausführungsformen können die Metallisierungen aus Aluminium (günstig als Spiegel in einem breitem Spektralbereich einschließlich UV) oder Silber (günstig als Spiegel im sichtbaren Spektralbereich) bestehen. In einer Ausgestaltung wird das Decksubstrat, bei dem es sich beispielsweise um einen unstrukturierten Glas-Wafer handelt, aufgeklebt. Das Rückdünnen des Substrats wird beispielsweise mittels Ätzen und / oder mechanischer Bearbeitung ausgeführt.

Ein Bonden von Substrat und Decksubstrat vor dem Rückdünnen kann mittels Klebebonden (adhäsives Fügen) realisiert werden. Im Falle von Siliziumabstandshalter und Decksubstrat aus alkalihaltigem Glas ist das Fügen auch über einen anodischen Bond möglich. Die Grenzschicht zwischen beiden Substraten ist beim anodischen Bond voll hermetisch; beim normalen Verkleben nur quasi-hermetisch. Vorgesehen sein kann auch das Aufbringen einer strukturierten Schicht aus alkalihaltigem Aufdampfglas auf ein Decksubstrat aus Silizium und das anschließende Fügen von Si-Abstandselement und Decksubstrat, wiederum über anodischen Bond. Es kann eine Verbindung von strukturiertem Abstandselement und Decksubstrat über einen Direkt-Bond (Fügen von polierten Flächen miteinander, wahlweise unter einer Plasmavorbehandlung oder einer thermischen Nachbehandlung) vorgesehen sein. Mittels Aufbringen entsprechender Metallisierungen auf der Oberfläche des Abstandselements und des Decksubstrates ist das Fügen bei entsprechenden Temperaturen auch über einen so genannten Eutektischen Bond möglich, wobei als Metallisierungspartner zum Beispiel Kupfer und Zinn eingesetzt werden können. Auch ein Lötbond kann genutzt werden. Hierbei handelt es sich um ein strukturiertes Aufbringen von Lötpaste oder Lotglas, zum Beispiel über Rakeln mit einem Sieb, und anschließendes Um- oder Aufschmelzen des Lots.

Zum Herstellen der Abstandselemente können Ätzprozesse eingesetzt werden. Nutzbar ist ein Nassätzen von Si in 100-Orientierung über eine wässrige KOH-Lösung. Es entstehen ätzbegrenzende Ebenen entlang der 111-Orientierung mit typischem Winkel von 54,7°. Bei anderen Oberflächenorientierungen sind entsprechend andere Flankenwinkel realisierbar. Mit Trockenätzprozessen sind die Herstellung und die gezielte Einstellung von hierzu abweichenden Flankenwinkeln möglich. So können je nach Anwendung deutlich flachere Winkel, zum Beispie! 30° bis 45°, oder steilere Winkel, zum Beispiel 60° bis 90°, hergestellt werden. Für bestimmte Anwendungen können angepasste Eintritts- oder Austrittswinkel bevorzugt sein. Das Ätzen von nahezu senkrechten Wänden ist mit Trockenätzprozessen (Bosch-Prozess) ebenfalls möglich. Ebenfalls ist mit Trockenätzprozessen ein nicht monoton stetiger Verlauf, also das Ausbilden von gekrümmten Flächen der Ätzflanken möglich. Dies könnte zum Beispiel für Mikro-Parabolspiegel Anwendung finden.

Eine bevorzugte Weiterbildung der Erfindung sieht vor, dass die eine oder die mehreren Vertiefungen in einem mehrstufigen Prozess gebildet werden, bei dem wahlweise eine weitere Vertiefung in einer bestehenden Vertiefung gebildet wird. Hierbei wird in einer Ausgestaltung quasi eine Vertiefung in der Vertiefung gebildet. Beispielsweise kann die weitere Vertiefung am Boden der zuvor erzeugten Vertiefung gebildet werden, sodass insgesamt eine größere Tiefe ausgebildet wird. Der mehrstufige Prozess wird in einer Ausführungsform mit Hilfe einer Maskierung durchgeführt, welche es ermöglicht, nach dem Ausbilden einer ersten Vertiefung Teile hiervon abzuschatten, um die weitere Vertiefung in der bestehenden Vertiefung zu erzeugen. Als Maskierungstechnologien können zum Beispiel die Nutzung einer (separaten) Metallmaske, durch welche hindurch gedampft werden kann, und / oder die Verwendung einer Photolackmaske auf dem Substrat zum Einsatz kommen. Es kann auch vorgesehen sein, einen mehrstufigen Prozess dahingehend auszubilden, dass alternativ oder ergänzend zum Herstellen der weiteren Vertiefung in der bestehenden Vertiefung nacheinander in mehreren Prozessschritten Vertiefungen unterschiedlicher_Ausprägung erzeugt werden. Auch hierzu ist die Schattenmasken-Technologie nutzbar, die es ermöglicht, Bereiche innerhalb der einzelnen Prozessschritte abzuschatten.

Bei einer zweckmäßigen Ausgestaltung der Erfindung kann vorgesehen sein, dass mehrere Vertiefungen gebildet werden, die sich hinsichtlich eines oder mehrerer der folgenden Vertiefungsparameter unterscheiden: Querschnittsgröße, Querschnittsform und Höhe. Bei dieser oder anderen Ausführungsformen kann vorgesehen sein, dass Rückdünnen mehrstufig auszuführen, d. h. mit Hilfe mehrerer aufeinanderfolgender Prozessschritte. In diesem Zusammenhang kann in einer Ausgestaltung die Schattenmasken-Technologie genutzt werden, um bei einem Prozessschritt des Rückdünnens Bereiche abzuschatten, die in einem anderen Prozessschritt oder gar nicht rück zu dünnen sind.

Eine vorteilhafte Ausführungsform der Erfindung sieht vor, dass beim Rückdünnen des Substrats ein Abschnitt des Substrates in größerem Umfang rückgedünnt wird als ein anderer Abschnitt des Substrats. Dieses kann beispielsweise mittels Abschatten von Abschnitten des Substrats ausgeführt werden oder selektiven mechanisch abrasiven Bearbeiten. Der in größerem Umfang rückgedünnte Abschnitt kann mehrere Teilabschnitte umfassen, die zusammenhängend oder vereinzelt gebildet sind.

Bevorzugt sieht eine Fortbildung der Erfindung vor, dass eine dem Hohlraum zugewandte Kontur der Abstandshalter gebildet wird, indem eine Teilkonturierung sowohl beim Ausbilden der einen oder der mehreren Vertiefungen als auch beim Rückdünnen des Substrats ausgeführt wird. Bei dieser Ausführungsform findet die Ausbildung der Kontur der Abstandshalter auf der dem Hohlraum zugewandten Seite sowohl beim Herstellen der Vertiefung als auch beim Rückdünnen des Substrats statt. Auf diese Weise können beliebige Konturen hergestellt werden, die zum Beispiel auch Stufen oder Übergänge zwischen geraden und schrägen Wandabschnitten umfassen können.

Eine bevorzugte Weiterbildung der Erfindung sieht vor, dass das Herstellen der Abstandselemente einen Schritt zum Ausbilden eines Unterschnitts auf einer dem Decksubstrat zugewandten Seite der Abstandselemente umfasst. Bei einer zweckmäßigen Ausgestaltung der Erfindung kann vorgesehen sein, dass die Abstandselemente mit einer oder mehreren schräg verlaufenden Flächen gebildet werden. In einer Ausführungsform ist eine schräge Fläche im Bereich des Unterschnitts gebildet. Die schräg oder geneigt verlaufende Oberfläche, die innen und / oder außen an den strukturierten Abstandselementen gebildet werden kann, ist mit einer Neigung relativ zur vertikalen Achse der Geometrie der Anordnung hergestellt. In einer Ausgestaltung erstreckt sich die Schräge im Wesentlichen über die gesamte Höhe der Abstandselemente, also vom Trägersubstrat bis zum Decksubstrat. Hierbei kann eine durchgehend verlaufende einheitliche Schräge gebildet sein. Alternativ kann vorgesehen sein, mehrere zueinander versetzte schräge Flächenabschnitte herzustellen, die in einer Ausgestaltung wahlweise unterschiedliche Neigungen aufweisen. Auf den schrägen Flächen kann in einer Ausgestaltung eine Beschichtung mit einer oder mehreren dielektrischen Schichten vorgesehen sein, zum Beispiel zur Realisierung eines dielektrischen Spiegels mittels Aufbringen von dielektrischen Schichten mit alternierenden Brechungsindizes. Die dielektrischen Schichten können zum Beispiel mithilfe plasmagestützten Elektronenstrahl-Aufdampfens aufgebracht werden. Alternativ oder ergänzend kann die schräge Fläche mit einer gekrümmten Fläche gebildet werden, wobei eine konvexe oder eine konkave Ausbildung nutzbar ist. Es kann über die schräge Fläche eine durchgehende Krümmung gebildet sein. Alternativ erstreckt sich die Krümmung nur über einen Teilbereich der schrägen Seitenfläche des Abstandselementes. Auch können Teilbereiche einer schrägen Seitenfläche unterschiedliche Krümmungen aufweisen, die insbesondere durch verschiedenen Krümmungswinkel charakterisiert sind. Eine Ausgestaltung mit Krümmung kann auch im Zusammenhang mit nicht schräg verlaufenden Seitenflächen des Abstandselementes vorgesehen sein.

Eine vorteilhafte Ausführungsform der Erfindung sieht vor, dass das Herstellen der Abstandselemente einen Schritt zum Ausbilden einer Beschichtung auf den Abstandselementen in Form einer Metallisierung und / oder einer optischen Verspiegelung umfasst. In einer Ausführungsform ist die Metallisierung auf den dem Hohlraum zugewandten Oberflächenabschnitten der Abstandselemente gebildet. Diese Oberflächen können ganz oder teilweise mit der Metallisierung versehen sein. In einer Ausführungsform sind einander gegenüberliegende Seiten oder Flächen metallisiert. Die Metallisierung kann mikrostrukturiert sein.

Bevorzugt sieht eine Fortbildung der Erfindung vor, dass das Herstellen der Abstandselemente einen Schritt zum Ausbilden einer optisch-funktionalen Schicht auf den Abstandselementen umfasst. Der Begriff "optisch funktional" in der hier verwendeten Bedeutung bezieht sich auf eine Beeinflussung bestimmter Eigenschaften einer elektromagnetischen Strahlung, insbesondere Licht. Mittels der optisch-funktionalen Schicht kann eine optische Ver- oder Entspiegelung, ein dielektrischer Spiegel, eine Antireflexionsschicht, eine Filterschicht, eine Absorberschicht, ein diffraktiv optisches Element und / oder eine Gitterstruktur gebildet sein. So kann zum Beispiel mit Hilfe einer optischen Verspiegelung die Lichtreflexion auf den verspiegelten Flächen erhöht werden. In einer Ausführungsform ist die Metallisierung Teil der Verspiegelung. Es kann auch vorgesehen sein, dass die Verspiegelung ausschließlich mit Hilfe der Metallisierung hergestellt ist. Bevorzugt ist die optische Verspiegelung auf innen liegenden Oberflächen der strukturierten Abstandselemente gebildet, das heißt in Oberflächenbereichen, die dem Hohlraum zugewandt sind. Diese oder andere Oberflächenbereiche können teilweise oder vollständig mit der optischen Verspiegelung versehen sein.

Eine bevorzugte Weiterbildung der Erfindung sieht vor, dass ein oder mehrere Anschlüsse für eine elektrische Kontaktierung des Bauelementes hergestellt werden. Die elektrische Kontaktierung für das Bauelement, bei dem es sich bevorzugt um ein elektrisches oder elektronisches Bauelement handelt, kann zum Beispiel hergestellt werden, indem elektrische Verbindungen zwischen dem Hohlraum und der Außenseite durch einen Bereich zwischen den Abstandselementen und dem Trägersubstrat hindurchgeführt werden. In einer Ausführungsform umfasst die elektrische Kontaktierung dass Ausbilden von so genannten Vias durch das Trägersubstrat hindurch, so dass ein elektrischer Anschluss auf der Rückseite des Trägersubstrats, also auf der vom Hohlraum abgewandten Seite, erfolgen kann. Zum Beispiel können dort dann Lötkontakte für eine Bauelementmontage hergestellt werden. Es könnten auch Leiterbahnen über die schräge Fläche nach oben geführt werden, um elektrische Kontaktierungen des in dem Hohlraum eingeschlossenen Bauteils zu realisieren.

Bei einer zweckmäßigen Ausgestaltung der Erfindung kann vorgesehen sein, dass das Anordnen der an dem Decksubstrat angeordneten Abstandselemente auf der Deckfläche des Trägersubstrates als Kapselung im Wafer-Verbund ausgeführt wird. Bei dieser Ausgestaltung wird das Bauelement auf einem Wafer angeordnet und anschließend mit dem unvereinzelten Halbzeug mit einem oder mehreren strukturierten Abstandselementen und Decksubstrat gekapselt, das heißt in dem Hohlraum angeordnet. Vorgesehen sein kann auch das direkte Fügen des Halbzeugs aus strukturiertem Abstandselement und Decksubstrat auf einen unvereinzelten Device-Wafer (*Wafer-Level-Capping*)*.* Bei dieser Ausführungsform sind das eine oder die mehreren zu kapselnden Bauelemente in dem Device-Wafer gebildet.

Eine vorteilhafte Ausführungsform der Erfindung sieht vor, dass als Bauelement ein optoelektronisches Bauelement auf der Deckfläche des Trägersubstrates angeordnet wird. Bei dem optoelektronischen Bauelement kann es sich um ein lichtemittierendes oder ein lichtempfangendes Bauelement handeln. Ein lichtemittierendes Bauelement ist beispielsweise eine lichtemittierende Diode, sei es in organischer oder anorganischer Ausführungsform. Ein Beispiel für ein lichtempfangendes Bauelement ist die Photozelle, die auch in organischer oder anorganischer Bauform vorliegen kann.

Bevorzugt sieht eine Fortbildung der Erfindung vor, dass die Anordnung der SMD-Technologie (SMD - *"Surface Mounted Device*") entsprechend hergestellt wird. Dieses bedeutet in einer Ausführung insbesondere, dass die gekappselten Bauelemente mit herkömmlichen so genannten "Pick-and-Place"-Technologien, Lötpasten oder dergleichen weiterverarbeitet werden können. Das Trägersubstrat kann bei Verwendung dieser Technologie oder anderer Technologien aus mindestens einem Material ausgewählt aus der folgenden Gruppe von Materialien bestehen: Halbleiter wie Silizium, Keramik, Glas, Metallsubstrat und Kunststoff wie Leiterplatte oder Flex-Substrat, die bevorzugt mit entsprechenden Leiterbahnstrukturen und / oder Durchkontaktierungen (Vias) versehen sind. In einem besonderen Fall kann das Trägersubstrat der Device-Wafer selbst sein. Als Alternative zu einem Wafer-Level-Prozess kann vorgesehen sein, dass vorvereinzelte Kappen direkt auf eine Leiterplatte geklebt werden. Vorvereinzelte Kappen können auch direkt auf einen vereinzelten Chip geklebt werden. Das Decksubstrat kann aus Glas, zum Beispiel Borosilikatglas, Quarzglas, Saphirglas, Silizium, Keramik, Metall oder Kunststoff bestehen.

Bei einer vorteilhaften Ausgestaltung der Erfindung kann vorgesehen sein, dass das Decksubstrat auf der Rückseite zumindest in Bereichen, die nicht von den Abstandselementen bedeckt sind, wenigstens abschnittsweise mit einer Substratbeschichtung versehen wird. Die Substratbeschichtung auf der Rückseite kann auch als innere Beschichtung bezeichnet werden. Eine Beschichtung kann alternativ oder ergänzend auf der Vorderseite des Drecksubstrates gebildet sein, die auch als äußere Beschichtung bezeichnet werden kann. Die Beschichtung kann ein oder mehrlagig hergestellt werden. Die Substratbeschichtung auf der Vorder- und / oder der Rückseite des Decksubstrates kann als eine strukturierte Beschichtung, also eine nicht durchgehende oder teilweise unterbrochen gebildete Beschichtung, oder als eine flächig durchgehende Beschichtung ausgeführt sein. Handelt es sich bei dem Bauelement in dem Hohlraum um ein optoelektronisches Bauelement, kann die Beschichtung gebildet werden, um mit ihrer Hilfe durch das Decksubstrat hindurch tretendes Licht, sei es aus dem Hohlraum heraus oder in diesen hinein, zu beeinflussen, beispielsweise mittels Absorption und / oder Lichtumwandlung. So kann in einer Ausführungsform vorgesehen sein, in die Beschichtung auf der Vorder- und / oder der Rückseite Leuchtstoffe ("Phosphor") einzulagern, die Licht einer oder mehrerer Wellenlängen absorbieren und Licht mit einer oder mehreren anderen Wellenlängen wieder abgeben In einer Ausgestaltung ist die rückseitige Beschichtung als sogenannte Phosphorschicht hergestellt. Für die Anwendung als Kappe für eine LED-Anwendung (LED - Licht emittierende Diode) kann für die Konvertierung zu weißem Licht ein Leuchtstoff in die Kappe eingebracht werden. Möglich ist dies mittels Einbringen von Silikonen oder Epoxiden, die mit dem Leuchtstoff vermischt werden, in die Kappe nach dem Verbinden von Abstandselement und Decksubstrat. Nach Aushärten des Bindemittels wird dann anschließend dieses Halbzeug über einen Klebebond auf den Bauteilträger geklebt. Der Leuchtstoff kann auch in einen Fotolack eingebracht und photolithographisch strukturiert auf das Decksubstrat aufgetragen werden. Das Fügen von Abstandselement und Decksubstrat und von Halbzeug mit Bauteilträger erfolgt dann ebenfalls über Klebebonds.

Leuchtstoffe können auch in einen Kleber eingebracht und mittels Spin-Coating auf das Decksubstrat aufgebracht werden. Die Kleberschicht dient dann einerseits als Leuchtstoffmatrix und andererseits als Kleberschicht zum Fügen von strukturiertem Abstandselement und Decksubstrat. Alternativ können Leuchtstoffe in die Klebeschicht einer Folie eingebettet sein, die auf das Decksubstrat auflaminiert wird. Das Aufbringen des Leuchtstoffes auf das Decksubstrat kann auch über sogenannte Sol-Gel-Verfahren ermöglich werden. Die Leuchtstoffe werden hierzu in Mischungen von entsprechenden Sol-Gel-Edukten eingebracht. Nach einer entsprechenden Temperaturbehandlung bildet sich eine glasartige Schicht mit darin enthaltenen Leuchtstoffen. Eine Auswahl an Leuchtstoffen ist zum Beispiel in dem Dokument WO 2008/058619 A1 offenbart.

Das Herstellen von dielektrischen Beschichtungen auf der Vorder- und / oder der Rückseite des Decksubstrats erfolgt bevorzugt als Aufdampfschicht, wozu in einer Ausführungsform eine plasmagestützte thermische Verdampfung, insbesondere eine plasmagestützte Elektronenstrahlverdampfung verwendet wird. Aber auch andere Prozesse der Schichtabscheidung können je nach Anwendungsfall genutzt werden. Das Ausbilden der Beschichtung auf der Vorder- und / oder der Rückseite des Decksubstrats kann vor oder nach dem Herstellen der strukturierten Abstandselemente auf der Rückseite des Decksubstrats erfolgen. Mit Hilfe der Beschichtung kann in einer Ausführungsform eine Teilent- oder Teilverspiegelung hergestellt werden.

Die Beschichtungen auf der Vorder- und / oder der Rückseite des Decksubstrats kann als eine Metallschicht ausgeführt sein, die strukturiert oder unstrukturiert gebildet ist. Eine strukturierte Metallschicht kann beispielsweise zum optischen Abschatten bestimmter Bereiche auf dem Bauteil-Chip dienen oder direkt als Blende im aktiven Strahlengang sitzen.

Die Beschichtung auf der Vorder- und / oder der Rückseite kann in einer Ausgestaltung neben einer Antireflexionsschicht auch andere optische Funktionen erfüllen. Es kann die Ausbildung eines optisch diffraktiven Elementes, eines Filters oder einer Absorberschicht vorgesehen sein.

In besonderer Weise ist bei optischen Anwendungen die Integration von Linsen in konvexer, konkaver oder diffraktiver Bauweise auf der Vorder- und / oder der Rückseite des Decksubstrats von Vorteil. Linsen können am Decksubstrat aus Glas mittels Aufbringen von entsprechenden Strukturen aus Fotolack realisiert werden. So können ein Strukturieren von radialen Strukturen aus Fotolack und ein anschließendes Umschmelzen der Strukturen zu Linsen aus Fotolack vorgesehen sein. Mittels reaktiven Ionenätzen können die Linsenstrukturen ins Glas übertragen werden. Linsen können auch direkt in Polymeren mittels Abformung / Replizierung mit entsprechenden Masterwerkzeugen oder über lonenaustausch hergestellt werden.

Das Verbinden mehrerer Abstandselemente, welche beispielsweise mit dem mit Linsen versehenen Decksubstrat gefügt sind, erlaubt so das Aufbauen eines mehrlinsigen Bauteils. Auf diese Weise würde zum Beispiel ein Stapel von Elementen mit mehreren Decksubstraten und mehreren Abstandselementen entstehen, wobei die Decksubstrate mittels der Abstandselemente beabstandet sind.

Die Abstandselemente werden in einer zweckmäßigen Ausgestaltung mit einer Höhe von etwa 10µm bis etwa 300 µm, bevorzugt mit einer Höhe von etwa 30µm bis etwa 300µm und weiter bevorzugt mit einer Höhe von etwa 30µm bis etwa 100µm hergestellt.

Die Abstandselemente werden bei einer bevorzugten Ausführungsform der Erfindung aus einem Material ausgewählt aus der folgenden Gruppe von Materialien hergestellt: Glas, Keramik und Kunststoff. Hierbei handelt es sich um Materialien, die alternativ zu einem Halbleitermaterial, insbesondere Silizium, zum Einsatz kommen können.

In Verbindung mit vorteilhaften Ausgestaltungen der Anordnung gelten die im Zusammenhang mit zugehörigen Ausführungsformen des Verfahrens gemachten Erläuterungen entsprechend.

Wahlweise kann das Abstandselement in einer abweichenden Ausführungsform auf den mit Bauteilen vormontierten Träger gebondet und dann über Rückdünnen geöffnet werden. Die Montage des Decksubstrats erfolgt dann im letzten Prozessschritt. Bei dieser Ausführungsform werden zunächst eine oder mehrere Vertiefungen in dem Substrat für die Abstandshalter gebildet. Danach wird das Substrat auf den vormontierten Träger gebondet, derart, dass die Bauteile in den Vertiefungen angeordnet sind. Mittels Rückdünnen werden die Vertiefungen geöffnet, um schließlich das Decksubstrat aufzubringen. Alternativ kann vorgesehen sein, dass die Bauelemente nach dem Öffnen eingebracht werden, also nicht schon vormontiert sind.

In Verbindung mit dem Verfahren zum Herstellen eines Halbzeugs für eine Bauelementanordnung mit einem gekapselten Bauelement sowie das Halbzeug für eine Bauelementanordnung gelten die vorangehend gemachten Erläuterungen zu vorteilhaften Ausgestaltungen entsprechend, beispielsweise hinsichtlich der Ausgestaltung der Abstandselemente mit oder ohne schräge Seitenflächen.

### Beschreibung bevorzugter Ausführungsbeispiele

Die Erfindung wird im Folgenden anhand von bevorzugten Ausführungsbeispielen unter Bezugnahme auf Figuren einer Zeichnung näher erläutert. Hierbei zeigen:
- Fig. 1: eine schematische Darstellung zur Erläuterung mehrerer Verfahrensschritte beim Herstellen von Abstandselementen,
- Fig. 2: eine schematische Darstellung einer Anordnung, bei der Bauelemente jeweils in einem Hohlraum auf einem Trägersubstrat angeordnet sind,
- Fig. 3: eine schematische Darstellung zur Erläuterung mehrerer Verfahrensschritte beim Herstellen von Abstandselementen nach einer anderen Ausführungsform, bei der Vertiefungen in unterschiedlicher Ausbildung hergestellt werden,
- Fig. 4: eine schematische Darstellung zur Erläuterung mehrerer Verfahrensschritte beim Herstellen von Abstandselementen nach einer weiteren Ausführungsform, bei der ein Rückdünnen unter Verwendung einer Maskentechnologie ausgeführt wird,
- Fig. 5: eine schematische Darstellung einer Anordnung, bei der ein Bauelement auf einem Trägersubstrat in einem Hohlraum angeordnet ist, wobei Abstandselemente schräg verlaufende Seitenflächen im Hohlraumbereich aufweisen,
- Fig. 6: eine schematische Darstellung einer Anordnung, bei der auf einem Trägersubstrat ein Bauelement in einem Hohlraum angeordnet ist, wobei Abstandselemente parallel verlaufende Seitenwände aufweisen,
- Fig. 7: eine schematische Darstellung einer Anordnung, bei der auf einem Trägersubstrat und in einem Hohlraum angeordnete Bauelemente über Durchkontaktierungen mit rückseitigen Kontakten an dem Trägersubstrat verbunden sind,
- Fig. 8: eine schematische Darstellung einer weiteren Anordnung, bei der wie in Fig. 7 auf einem Trägersubstrat und in einem Hohlraum angeordnete Bauelemente über Durchkontaktierungen mit rückseitigen Kontakten an dem Trägersubstrat verbunden sind, wobei Abstandselemente parallel verlaufende Seitenwände aufweisen, und
- Fig. 9: eine schematische Darstellung einer weiteren Anordnung, bei der wie in Fig. 7 auf einem Trägersubstrat und in einem Hohlraum angeordnete Bauelemente über Durchkontaktierungen mit rückseitigen Kontakten an dem Trägersubstrat verbunden sind, wobei im Vergleich zu Fig. 7 schräge Seitenwände von Abstandselementen mit einer entgegengesetzten Neigung gebildet sind.

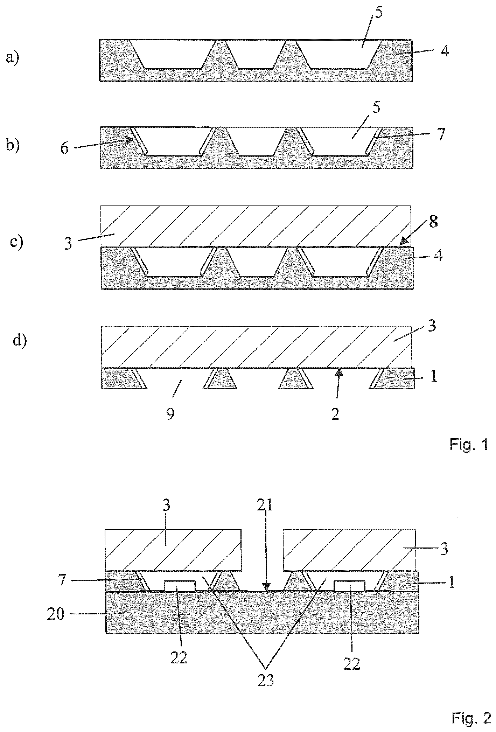

Fig. 1 zeigt eine schematische Darstellung zum Erläutern eines Verfahrens mit mehreren Schritten a) bis d) zum Ausbilden von Abstandselementen 1 in strukturierter Form auf einer Rückseite 2 eines Decksubstrats 3. Zunächst werden hierbei in einem Schritt a) gemäß Fig. 1 in einem Substrat 4, bei dem es sich beispielsweise um einen Halbleiter-Wafer handelt, Vertiefungen oder Gruben 5 hergestellt, zum Beispiel mittels Ätzen. In einer Ausführungsform wird zu diesem Zweck ein Siliziumsubstrat bearbeitet. Bei dem dargestellten Ausführungsbeispiel werden in einem Schritt b) anschließend schräg verlaufende Seitenflächen 6 der Vertiefungen 5 wenigstens teilweise mit einer Metallisierung 7 versehen, zum Beispiel aus Aluminium oder Silber. Anschließend wird in einem Schritt c) gemäß Fig. 1 auf eine Deckfläche 8 des Substrats 4 das Decksubstrat 3 aufgebracht, bei dem es sich beispielsweise um einen unstrukturierten Glas-Wafer handelt. Das Anordnen des Decksubstrats 3 erfolgt zum Beispiel mittels Aufbonden. Im folgenden Schritt d) wird gemäß Fig. 1 das Substrat 4 rückgedünnt, insbesondere mittels Ätzen und / oder mechanischer Bearbeitung, wodurch Ausnehmungen 9 geöffnet werden, die von den Abstandselementen 1 begrenzt sind.

Gemäß Fig. 2 wird die so hergestellte Anordnung aus Fig. 1 mit den auf der Rückseite des Decksubstrats 3 angeordneten Abstandselementen 1 dann auf ein Trägersubstrat 20 aufgebracht, und zwar auf eine Deckfläche 21 des Trägersubstrats 20, wo sich bereits Bauelemente 22 befinden. Auf diese Weise werden die Bauelemente 22 in Hohlräumen 23 angeordnet und gekapselt.

Bei der Anordnung gemäß Fig. 2 kann es sich beispielsweise um ein so genanntes Opto-Package handeln, bei dem die Bauelemente 22 als optoelektronische Bauelemente ausgeführt sind, die Licht abgeben oder empfangen. Die Metallisierung 7 dient hierbei in einer Ausgestaltung als eine Art optische Ver- oder Entspiegelung. Die Seitenwände der strukturierten Abstandselemente 1 sind zwischen Trägersubstrat 20 und Decksubstrat 3 schräg verlaufend.

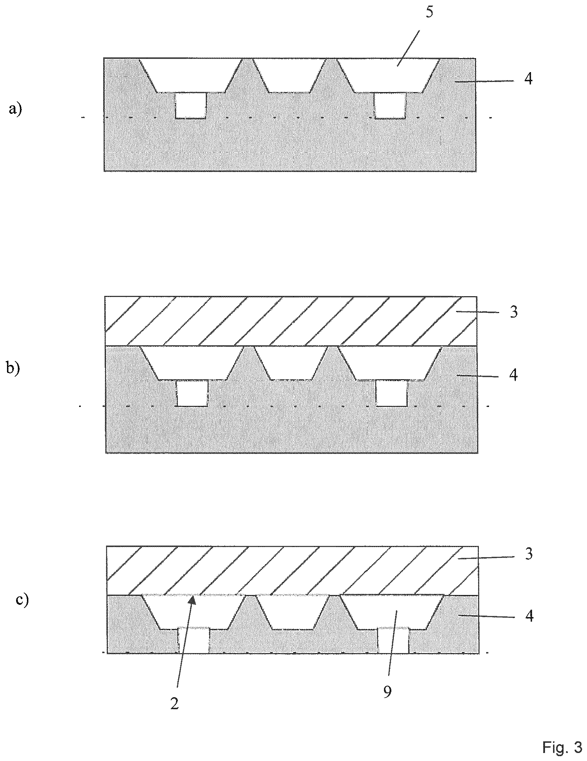

Fig. 3 zeigt vergleichbar Fig. 1 einen mehrstufigen Prozess zum Herstellen von Abstandselementen 1 in strukturierter Form auf der Rückseite 2 eines Decksubstrats 3. Im Unterschied zur Ausführungsform nach Fig. 1 erfolgt das Herstellen der Vertiefungen oder Gruben 5 im Schritt a) in dem Substrat 4 mehrstufig. Nachdem erste Vertiefungen 5a hergestellt sind, erfolgt in einem nächsten Schritt das Herstellen von weiteren Vertiefungen 5b in den vorhandenen Vertiefungen 5a. Auf diese Weise werden Vertiefungen 5 mit unterschiedlicher Ausgestaltung erzeugt. In den weiteren Schritten b) und c), die den Schritten c) und d) aus Fig. 1 entsprechen, erfolgen dann das Aufbringen des Decksubstrats 3 und das Rückdünnen des Substrats 4, bis die mittels der Vertiefungen 5 gebildeten Hohlräume auf der von dem Decksubstrat 3 abgewandten Seite geöffnet sind.

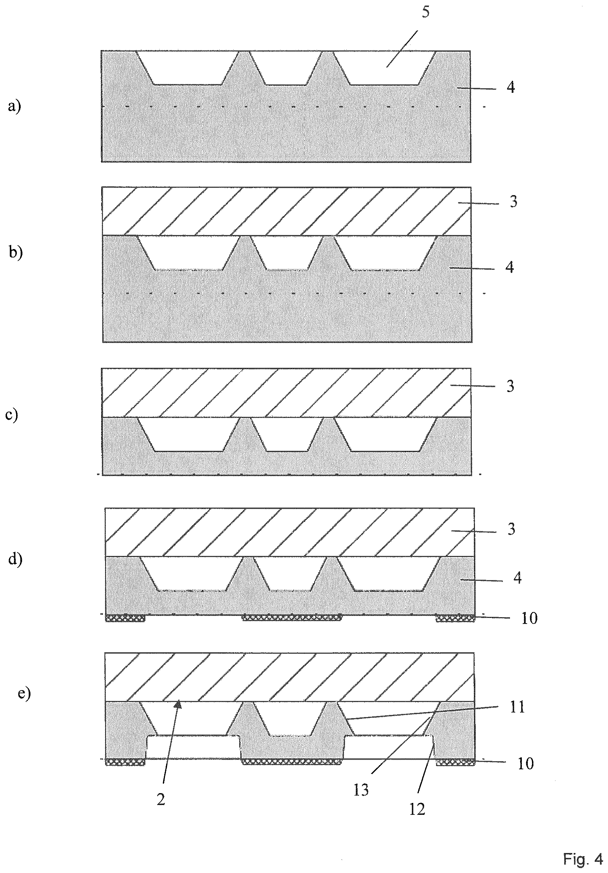

Fig. 4 zeigt eine schematische Darstellung zur Erläuterung mehrer Verfahrensschritte beim Herstellen von Abstandselementen 1 auf der Rückseite 2 des Decksubstrats 3 in einer weiteren Ausführungsform. Die in Fig. 4 dargestellten Schritte a) und b) entsprechen den Schritten a) und c) in Fig. 1. Im Unterschied zur Ausführungsform nach Fig. 1 erfolgt nun bei der Ausgestaltung nach Fig. 4 das Rückdünnen mehrstufig, wobei in einem Schritt c) ein Rückdünnen über die gesamte dargestellte Fläche des Substrats 4 erfolgt. Anschließend wird gemäß Schritt d) eine Maske 10 (Schattenmasken-Technologie) aufgebracht, um im Schritt e) die nicht mit der Maske 10 bedeckten Flächen des Substrats 4 weiter rückzudünnen, bis die Vertiefungen 5 auf der von dem Decksubstrat 3 abgewandten Seite geöffnet sind.

Beim Rückdünnen erfolgt gleichzeitig eine weitere Strukturierung von Seitenflächen 11, die hinsichtlich ihrer Kontur weiter ausgebildet werden. Während ein unterer Abschnitt 12 der Seitenfläche 11 eher vertikal verläuft, ist der benachbart zum Decksubstrat 4 gebildete obere Abschnitt 13 der Seitenfläche 11 schräg ausgeführt. Es kann vorgesehen sein, den unteren Abschnitt 12 und den oberen Abschnitt 13 der Seitenfläche 11 mit unterschiedlichen Beschichtungen und / oder Oberflächenstrukturierungen zu versehen. Beispielsweise verfügt der obere Abschnitt 13 über eine Beschichtung, mit der ein Farbfilter, ein Spiegel, ein Absorber, ein Diffuser, eine Linse, ein Gitter, eine Leiterbahn oder eine Bondfläche gebildet sind. Ausgewählt aus dieser Gruppe kann dann der untere Abschnitt 12 ganz oder teilweise andersartig beschichtet sein.

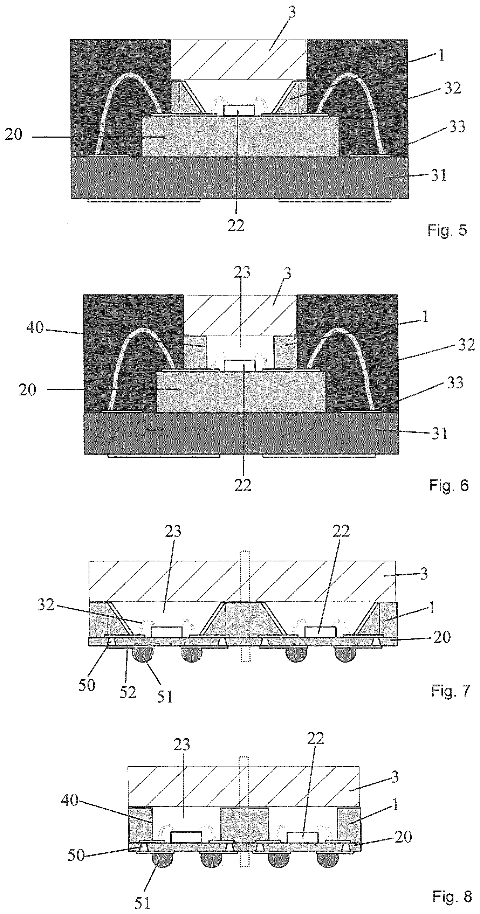

Nachfolgend werden unter Bezugnahme auf die Fig. 5 bis 9 weitere Ausführungsformen beschrieben. Hierbei werden für gleiche Merkmale die gleichen Bezugszeichen wie in den Fig. 1 bis 4 verwendet.

Fig. 5 zeigt eine schematische Darstellung einer Anordnung, bei der vergleichbar der Anordnung in Fig. 2 ein Bauelement 22 in dem Hohlraum 23 angeordnet ist, welcher mit schräg verlaufenden Seitenwänden gebildet ist. Das Trägersubstrat 20 ist auf einem weiteren Substrat 31 aufgebracht. Über eine elektrische Kontaktierung 32 ist das Bauelement 22 mit Anschlüssen 33 verbunden.

Fig. 6 zeigt eine schematische Darstellung einer Anordnung, bei der die Abstandselemente 1 mit parallel verlaufenden Seitenflächen oder -wänden 40 gebildet sind, insbesondere auch auf der dem Hohlraum 23 zugwandten Innenseite. Die geraden Seitenwände 40 der Abstandselemente 1 können zum Beispiel mittels Trockenätzverfahren realisiert werden, im Fall der Verwendung von Si zum Beispiel mittels eines Bosch-Prozesses. Im Übrigen ist die Ausführung der Anordnung in Fig. 6 vergleichbar zu der Ausführungsform in Fig. 5.

Fig. 7 zeigt eine schematische Darstellung einer Anordnung, bei der zwei Bauelemente 22 in benachbarten Hohlräumen 23 angeordnet sind, wobei über Durchkontaktierungen 50 die Bauelemente 22 mit rückseitigen Lötkontakten 51 verbunden sind. Die rückseitigen Lötkontakte 51 sind mit einer zugeordneten Umverdrahtung 52, die als Fan-In oder Fan-Out ausgeführt ist, mit der Durchkontaktierungen 50 verbunden. Die Ausführungsform in Fig. 5 entspricht der so genannten SMD-Technologie (SMD - *"Service Monted Device*")*.* Die SMD-Technologie ermöglicht eine direkte Montage des Bauelementes, zum Beispiel auf einer Leiterplatte. Eine Kontaktierung erfolgt beispielsweise über Lötkontakt oder über einen elektrisch leitfähigen Kleber. Die Anordnung aus Fig. 7 kann auch mit strukturierten Abstandselementen hergestellt werden, die parallel verlaufende Seitenwände 40 aufweisen, was in Fig. 8 gezeigt ist.

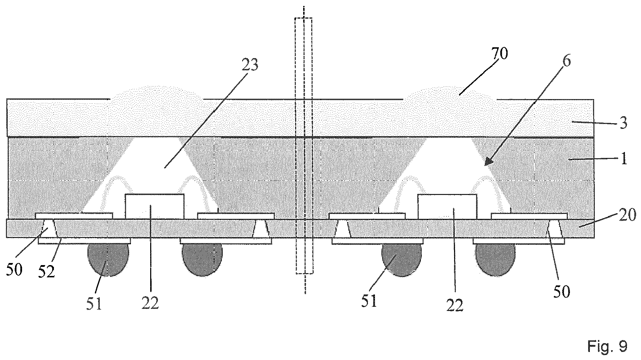

Fig. 9 zeigt eine schematische Darstellung einer weiteren Anordnung, bei der wie in Fig. 7 auf einem Trägersubstrat und in einem Hohlraum 23 angeordnete Bauelemente 22 über Durchkontaktierungen 50 mit rückseitigen Lötkontakte 51 an dem Trägersubstrat 20 verbunden sind. Im Unterschied zu Fig. 7 weisen die schrägen Seitenwände 6 innenseitig eine entgegengesetzte Neigung auf. Das Decksubstrat 3 ist auf der Oberfläche mit mikrostrukturierten Linsen 70 versehen. In einer Ausführungsform werden die schrägen Seitenflächen 6 des Abstandselements 1 zuvor beispielsweise mittels einer Plasmavorbehandlung oder Sandstrahlen aufgerauht. Dies hat im Falle des Linsen / Blenden-Aufbaus den Vorteil, dass ein störender Einfluss von Streulicht in der Kappe vermieden werden kann.

Abweichend von dem vorangehend beschriebenen Verfahren kann bei dieser Ausführungsform auch ein anderer Herstellungsprozess genutzt werden. Zum Beispiel wird ein mittels KOH-Ätzen Abstandselement 1 aus Silizium zuerst auf den Bauteilträger geklebt. Danach erfolgt das Fügen mit dem Decksubstrat 3. Die schmale Öffnung der Abstandselemente 1 liegt dann am Decksubstrat 3 an und bildet eine optische Blende.

Alternativ ist auch die Herstellung eines Halbzeugs bestehend aus einem oder mehreren vollständig durchstrukturierten Abstandselementen mit Schrägen auf einem Decksubstrat möglich, welches anschließend mit einem mit Bauteilen bestückten Träger verbunden wird. Bei dieser Art der Herstellung erfolgt die Ausbildung des einen oder der mehreren Abstandselemente ohne einen Verfahrensschritt zum Rückdünnen.

Die in der vorstehenden Beschreibung, den Ansprüche und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Verfahren zum Herstellen einer Anordnung mit einem Bauelement auf einem Trägersubstrat, wobei das Verfahren die folgenden Schritte umfasst:
- Herstellen von Abstandselementen auf der Rückseite eines Decksubstrats, wobei hierbei die folgenden Schritte vorgesehen sind:
- Bereitstellen eines Substrats,
- Herstellen einer oder mehrerer Vertiefungen im Bereich einer ausgewählten Oberfläche des Substrats,
- Anordnen des Decksubstrates auf der ausgewählten Oberfläche des Substrats, derart, dass wenigstens ein Vertiefungshohlraum gebildet wird, und
- Rückdünnen des Substrats von einer zur ausgewählten Oberfläche entgegen gesetzten Oberfläche des Substrats aus, derart, dass der wenigstens eine Vertiefungshohlraum geöffnet wird und so getrennte Abstandselemente gebildet werden, die zusammen mit dem Decksubstrat wenigstens einen Hohlraum begrenzen, der im Bereich der entgegen gesetzten Oberfläche des Substrats geöffnet ist,
- Anordnen eines Bauelementes auf einer Deckfläche eines Trägersubstrates und
- Anordnen der an dem Decksubstrat gebildeten Abstandselemente auf dem Trägersubstrat, derart, dass das Bauelement in dem wenigstens einen Hohlraum angeordnet und dieser geschlossen wird.

2. Verfahren nach Anspruch 1, **dadurch gekennzeichnet, dass** die eine oder die mehreren Vertiefungen in einem mehrstufigen Prozess gebildet werden, bei dem wahlweise eine weitere Vertiefung in einer bestehenden Vertiefung gebildet wird.

3. Verfahren nach Anspruch 1 oder 2, **dadurch gekennzeichnet, dass** mehrere Vertiefungen gebildet werden, die sich hinsichtlich eines oder mehrerer der folgenden Vertiefungsparameter unterscheiden: Querschnittsgröße, Querschnittsform und Höhe.

4. Verfahren nach mindestens einem der vorangehenden Ansprüche, **dadurch gekennzeichnet, dass** beim Rückdünnen des Substrats ein Abschnitt des Substrates in größerem Umfang rückgedünnt wird als ein anderer Abschnitt des Substrats.

5. Verfahren nach mindestens einem der vorangehenden Ansprüche, **dadurch gekennzeichnet, dass** eine dem Hohlraum zugewandte Kontur der Abstandshalter gebildet wird, indem eine Teilkonturierung sowohl beim Ausbilden der einen oder der mehreren Vertiefungen als auch beim Rückdünnen des Substrats ausgeführt wird.

6. Verfahren nach mindestens einem der vorangehenden Ansprüche, **dadurch gekennzeichnet, dass** das Herstellen der Abstandselemente einen Schritt zum Ausbilden einer Beschichtung auf den Abstandselementen in Form einer Metallisierung und / oder einer optischen Verspiegelung umfasst.

7. Verfahren nach mindestens einem der vorangehenden Ansprüche, **dadurch gekennzeichnet, dass** ein oder mehrere Anschlüsse für eine elektrische Kontaktierung des Bauelementes hergestellt werden.

8. Verfahren nach mindestens einem der vorangehenden Ansprüche, **dadurch gekennzeichnet, dass** das Anordnen der an dem Decksubstrat angeordneten Abstandselemente auf der Deckfläche des Trägersubstrates als eine Kapselung im Wafer-Verbund ausgeführt wird.

9. Verfahren nach mindestens einem der vorangehenden Ansprüche, **dadurch gekennzeichnet, dass** als Bauelement ein optoelektronisches Bauelement auf der Deckfläche des Trägersubstrates angeordnet wird.

10. Verfahren nach mindestens einem der vorangehenden Ansprüche, **dadurch gekennzeichnet, dass** die Anordnung der SMD-Technologie (SMD - *"Surface Mounted De*vice") entsprechend hergestellt wird.

11. Verfahren nach mindestens einem der vorangehenden Ansprüche, **dadurch gekennzeichnet, dass** das Decksubstrat auf der Rückseite zumindest in Bereichen, die nicht von den Abstandselementen bedeckt sind, wenigstens abschnittsweise mit einer Substratbeschichtung versehen wird.

12. Verfahren nach mindestens einem der vorangehenden Ansprüche, **dadurch gekennzeichnet, dass** die Abstandselemente mit einer Höhe von etwa 10µm bis etwa 300 µm, bevorzugt mit einer Höhe von etwa 30µm bis etwa 300µm und weiter bevorzugt mit einer Höhe von etwa 30µm bis etwa 100µm hergestellt werden.

13. Anordnung, mit:
- einem Trägersubstrat,
- einem gekapselten Bauelement, welches auf einer Deckfläche des Trägersubstrates in einem Hohlraum angeordnet ist, und
- einer elektrischen Kontaktierung des Bauelementes,
wobei der Hohlraum mittels auf der Deckfläche des Trägersubstrates angeordneter Abstandselemente und eines auf den Abstandselementen lagernden Decksubstrats gebildet ist und wobei die Abstandselemente eine dem Hohlraum zugewandte Kontur aufweisen.

14. Anordnung nach Anspruch 13, **dadurch gekennzeichnet, dass** das Bauelement ein optoelektronisches Bauelement ist.

15. Verfahren zum Herstellen eines Halbzeugs für eine Bauelementanordnung mit einem gekapselten Bauelement, wobei das Verfahren die folgenden Schritte umfasst:
- Bereitstellen eines Decksubstrats und
- Herstellen von Abstandselementen und eines zwischen den Abstandselementen gebildeten Aufnahmeraums auf einer Rückseite des Decksubstrates, wobei der Aufnahmeraum konfiguriert ist für eine gekapselte Aufnahme wenigstens eines Bauelementes beim Anordnen des Decksubstrates auf einem Trägersubstrat,
wobei das Herstellen der Abstandselemente die folgenden Schritte umfasst:
- Bereitstellen eines Substrats,
- Herstellen einer oder mehrerer Vertiefungen im Bereich einer ausgewählten Oberfläche des Substrats,
- Anordnen des Decksubstrates auf der ausgewählten Oberfläche des Substrats, derart, dass wenigstens ein Vertiefungshohlraum gebildet wird, und
- Rückdünnen des Substrats von einer zur ausgewählten Oberfläche entgegen gesetzten Oberfläche des Substrats aus, derart, dass der wenigstens eine Vertiefungshohlraum geöffnet wird und so getrennte Abstandselemente gebildet werden, die zusammen mit dem Decksubstrat den Aufnahmeraum begrenzen, der im Bereich der entgegen gesetzten Oberfläche des Substrats geöffnet ist.
